# EUROPEAN PATENT SPECIFICATION

(11) **EP 3 273 469 B1**
(45) Date of publication and mention of the grant of the patent: **13.05.2020**
(21) Application number: 16885456.0
(22) Date of filing: 24.10.2016
(51) Int. Cl.: H01L 23/31, H01L 23/48, G06K 9/00

(54) **SILICON THROUGH HOLE CHIP AND MANUFACTURING METHOD THEREFOR, AND TERMINAL DEVICE**
SILIZIUMDURCHKONTAKTIERUNGSCHIP UND HERSTELLUNGSVERFAHREN DAFÜR, SOWIE ENDGERÄTEVORRICHTUNG
PUCE À TROU TRAVERSANT DE SILICIUM ET SON PROCÉDÉ DE FABRICATION, ET DISPOSITIF TERMINAL

(30) Priority: 19.05.2016 CN 201620460572 U
(43) Date of publication of application: 24.01.2018
(73) Proprietor: Shenzhen Goodix Technology Co., Ltd., Futian Free Trade Zone Shenzhen, Guangdong 518000 (CN)
(72) Inventor: WU, Baoquan, Shenzhen Guangdong 518000 (CN)
(74) Representative: Isarpatent
(86) International application number: PCT/CN2016/103055
(87) International publication number: WO 2017/197831

(56) References cited:
- CN-A- 103 000 648
- CN-A- 103 050 458
- CN-U- 204 067 418
- CN-U- 204 614 772
- JP-A- 2010 263 130
- US-A1- 2011 169 139
- US-A1- 2012 184 070
- US-A1- 2013 065 390
- US-A1- 2013 119 556

## Description

### TECHNICAL FIELD

The present application relates to the field of packaging technologies, and in particular, to a through silicon via chip and manufacturing method thereof, a fingerprint identification sensor and a terminal device.

### BACKGROUND

A wafer level through silicon via packaging technology is widely used in consumer electronic chips. Currently, a large number of oblique through silicon vias are applied to consumer electronic products, such as an image identification sensor, and the oblique through silicon via has advantages of low manufacturing difficulty and low cost.

An oblique through silicon via chip has a step structure. In a case of a through silicon via chip die, a fracture occurs easily at the step when a test and a process such as surface bonding and welding are performed.

JP2010263130A discloses a semiconductor device including a semiconductor substrate in which a substrate through hole 10H is formed penetrating a first principal surface 10A and a second principal surface 10B; a multilayer wiring layer 15 including an interlayer insulating film 13 in which an interlayer through hole 13H is formed; the through wiring 19 arranged from the electrode pad 16 to the side of the second principal surface 10B through a side wall of the interlayer film through hole 13H and a side wall of the substrate through hole 10H; and a bump 21 arranged on the through wiring 19 on the side of the second principal surface 10B. The insides of the substrate through holes 10H and the interlayer film through holes 13H are filled with the filling layer 22.

US2012184070A1 discloses a chip package, comprising: a substrate having a first surface 100a and a second surface 100b, wherein at least two conducting pads are disposed on the first surface of the substrate; at least two holes extending towards the first surface, wherein the holes respectively and correspondingly align with one of the conducting pads; at least a recess extending towards the first surface from the second surface of the substrate, wherein the recess overlaps with the holes; an insulating layer on a sidewall and a bottom of the recess and on sidewalls of the holes; a conducting layer on the insulating layer, wherein the conducting layer electrically contacts with one of the conducting pads; and a protection layer 114 on the second surface of the substrate, wherein the protection layer has at least an opening exposing the conducting layer.

### SUMMARY

Embodiments of the present application provide a through silicon via chip according to claim 1 and manufacturing method according to claim 9, and a terminal device, which can enhance structural strength of the through silicon via chip.

According to a first aspect, a through silicon via chip is provided, where the through silicon via chip comprises a silicon substrate, the silicon substrate is provided with a via, the via is a step structure with inclined sidewalls, and a backfill structure layer is disposed in the via; a first insulating layer, a rewiring metal layer and a second insulating layer are orderly disposed between the backfill structure layer and the silicon substrate; and the first insulating layer, the rewiring metal layer and the second insulating layer extend to a lower surface of the through silicon via chip, and a lower surface of the backfill structure layer is flush with a lower surface of an aggregation of the through silicon via chip, the first insulating layer, the rewiring metal layer and the second insulating layer.

A via is disposed on the substrate, and the via may be achieved by etching, so that electrical interconnection is performed between an element of an upper surface of the silicon substrate and another element at a lower surface of the though silicon via chip. The through silicon via chip fractures easily since a lower part of the via is hollow. Therefore, in an embodiment of the present application, the backfill structure layer is disposed at the lower part of the via for supporting the through silicon via chip, and a lower surface of the backfill structure layer is flush with the lower surface of the through silicon via chip. This can facilitate subsequent surface mounting and welding, and enhance structural strength of the through silicon via chip.

The rewiring metal layer is disposed between the backfill structure layer and the silicon substrate, and the rewiring metal layer passes through the via to implement conduction between the rewiring metal layer and another element at the lower surface of the through silicon via chip. Since a material of the silicon substrate is silicon, an insulating layer should be disposed between the rewiring metal layer and the silicon substrate, an insulating layer should also be disposed between the rewiring metal layer and the backfill structure layer, and these insulating layers play a protective role. The first insulating layer and the second insulating layer may be the same or different, which is not limited in the present application.

With reference to the first aspect, in a first possible implementation manner of the first aspect, a surface pad is disposed at a top of the via, and a lower surface of the surface pad is connected with the rewiring metal layer.

The surface pad is connected with the rewiring metal layer, that is, no insulating layer is disposed between the surface pad and the rewiring metal layer. The via may be configured in a manner that the first insulating layer, the rewiring metal layer and the second insulating layer are orderly disposed outwardly from a center axis of the via, and only the rewiring metal layer is connected with the surface pad. In this case, the surface pad of the through silicon via chip is conductive with the rewiring metal layer to implement electrical interconnection between an electrical element at an upper surface of the through silicon via chip and an electrical element at the lower surface of the through silicon via chip.

With reference to the first aspect, in a second possible implementation manner of the first aspect, a wall of the via is at an angle of 60 degree with respect to an upper surface of the through silicon via chip.

The via may also be a connection of a plurality of via structures with different apertures and the like, which is not limited in the present application. The via, for example, may be configured in a manner that the wall is at an angle of 60 degree with respect to the upper surface of the through silicon via chip, thereby reducing manufacturing difficulty.

With reference to the first aspect, in a third possible implementation manner of the first aspect, the silicon substrate is provided with a plurality of the vias.

In the present application, the plurality of the vias may implement interconnection between different surface pads of an upper surface of the silicon substrate, or electrical interconnection between the upper surface of the silicon substrate and an electrical element at the lower surface of the through silicon via chip.

According to a third aspect, a terminal device is provided, where the terminal device includes the though silicon via chip according to the first aspect.

Based on the foregoing technical solutions, according to a though silicon via chip of the embodiments of the present application, a backfill structure layer is added in an oblique via to play a supportive role when a force is exerted on a surface of the through silicon via chip, which avoids a fracture of the through silicon via chip, thereby enhancing structural strength of the through silicon via chip.

### BRIEF DESCRIPTION OF DRAWINGS

To describe technical solutions in embodiments of the present application more clearly, the following briefly introduces accompanying drawings required for describing the embodiments of the present application. Apparently, the accompanying drawings in the following description show merely some embodiments of the present application, and a person of ordinary skill in the art may still derive other drawings from these accompanying drawings without creative efforts.
FIG. 1 is a sectional view of a general through silicon via chip;
FIG. 2 is a sectional view of a through silicon via chip according to an embodiment of the present application;
FIG. 3 is a schematic view of an inverted wafer level through silicon via chip according to an embodiment of the present application;
FIG. 4 is a schematic view of a wafer level through silicon via chip provided with a structure backfill layer according to an embodiment of the present application; and
FIG. 5 is a schematic view of a single through silicon via chip according to an embodiment of the present application.

### DESCRIPTION OF EMBODIMENTS

The following clearly and completely describes technical solutions in embodiments of the present application with reference to accompanying drawings in the embodiments of the present application.

A through silicon via chip according to the embodiments of the present application may be applied to a terminal device, and the terminal device may include but is not limited to a cell phone, a tablet computer, an electronic book, a mobile station, or the like.

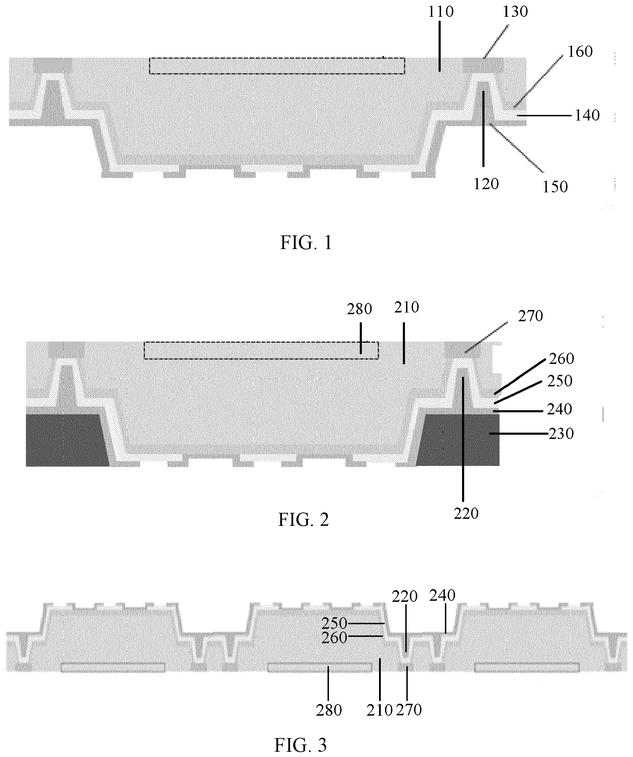

Referring to FIG 1, a via is generally formed in a silicon substrate 110 by two-stage etching for an oblique through silicon via chip, and the via includes a small hole 120 at an upper part and a large hollow hole at a lower part, as shown in FIG.1. A rewiring metal layer 140 in the via enables a surface pad 130 of an upper surface of the through silicon via chip to be electronically interconnected with another element at a lower surface of the though silicon via chip. A wall of the via and the rewiring metal layer 140 are isolated from each other through an insulating layer 160, and the rewiring metal layer 140 is provided with an insulating layer 150 for protection. For example, FIG. 1 shows a single through silicon via chip. In this case, the small hole 120 may be regarded as a protruding step, and the large hole is hollow. A fracture occurs easily at the step when a test and a process such as surface bonding and welding are performed.

FIG. 2 shows a partial sectional view of a through silicon via chip according to an embodiment of the present application. As shown in FIG 2, the through silicon via chip includes a silicon substrate 210, the silicon substrate 210 is provided with a via 220, the via 220 is an oblique via, and a backfill structure layer 230 is disposed in the via 220.

Specifically, as shown in FIG. 2, the via 220 in the silicon substrate 210 is a step structure, including a small hole at an upper part and a large hole at a lower part, and the via 220 may be achieved by two-stage etching. The through silicon via chip is easily fractured at the protruding step structure of the through silicon via chip since the large hole at the lower part of the via 220 is hollow. Therefore, in the embodiment of the present application, the backfill structure layer 230 is disposed in the via 220 for supporting the protruding step structure of the through silicon via chip.

It should be understood that, the via is formed by enclosing of a wall, and the wall is the silicon substrate.

Therefore, according to the though silicon via chip of the embodiment of the present application, the backfill structure layer 230 is added in the oblique via to play a supportive role when a force is exerted on a surface of the through silicon via chip, which avoids a fracture of the through silicon via chip, thereby enhancing structural strength of the through silicon via chip.

According to the invention, a lower surface of the backfill structure layer 230 is flush with a lower surface of the through silicon via chip. In this case, in the subsequent surface mounting and welding, a contact area of a bottom of the through silicon via chip is larger, which is beneficial to apportioning pressure, thereby enhancing the structural strength of the through silicon via chip.

Optionally, the wall of the oblique via may be at an angle of 60 degree with respect to an upper surface of the through silicon via chip.

It should be understood that the wall of the oblique via may also be at any angle with the upper surface of the through silicon via chip, which is not limited in the present application.

Optionally, a first insulating layer 240, a rewiring metal layer 250 and a second insulating layer 260 are orderly disposed between the backfill structure layer 230 and the silicon substrate 210.

The rewiring metal layer 250 is disposed between the backfill structure layer 230 and the silicon substrate 210, and the rewiring metal layer 250 passes through the via 220 to implement conduction between an electrical element at the upper surface of the through silicon via chip and an electronical element at the lower surface of the through silicon via chip. The second insulating layer 260 should be disposed between the rewiring metal layer 250 and the silicon substrate 210, and the first insulating layer 240 should also be disposed between the rewiring metal layer 250 and the backfill structure layer 230. The first insulating layer and the second insulating layer may be the same or different, which is not limited in the present application.

It should be understood that, a material of the insulating layer may be plastic insulation, such as polyvinyl chloride, polyethylene, or crosslinked polyethylene, and the material of the insulating layer may also be rubber, such as natural rubber, butyl rubber, or ethylene propylene rubber, which is not limited in the present application.

It should further be understood that, a height of a lower surface of the backfill structure layer 230 should be consistent with an aggregation of the through silicon via chip, the first insulating layer 240, the rewiring metal layer 250 and the second insulating layer 260 if the foregoing three layers of the through silicon via chip extend to the lower surface of the through silicon via chip.

Optionally, a material of the backfill structure layer 230 and materials of the silicon substrate 210, the rewiring metal layer 250, the first insulating layer 240 and the second insulating layer 260 are matched with each other in performance of cold and heat shrinkage.

Specifically, when a material of the backfill structure layer is selected, it should be considered that the material of the backfill structure and the material of each layer between the backfill structure and the silicon substrate 210 (i.e., the rewiring metal layer 250, the first insulating layer 240 and the second insulating layer 260) are matched in the performance of cold and head shrinkage. That is to say, the material of the backfill structure should be a material matched with silicon, and the materials of the first insulating layer, the second insulating layer and the rewiring metal layer in the performance of cold and heat shrinkage, such as rubber, plastics, or the like, which is not limited in the present application.

Optionally, a surface pad 270 is disposed at a top of the via 220, and a lower surface of the surface pad 270 is connected with the rewiring metal layer 250.

Specifically, the surface pad 270 may be disposed at the top of the via 220, and the surface pad 270 of the through silicon via chip is embedded in the upper surface of the silicon substrate 210 (i.e., the upper surface of the through silicon via chip); that is to say, the surface pad 270 covers the via 220, and is connected with the rewiring metal layer 250, that is, no insulating layer is disposed between the surface pad 270 and the rewiring metal layer 250. The via 220 may be configured in a manner that the first insulating layer 240, the rewiring metal layer 250 and the second insulating layer 260 are orderly disposed outwardly from a center axis of the via, and the rewiring metal layer 250 is connected with the surface pad 270. In this case, the surface pad 270 of the through silicon via chip is conductive with the rewiring metal layer 250 to implement electrical interconnection between an electrical element at the upper surface of the through silicon via chip and an electrical element at the lower surface of the through silicon via chip.

Optionally, a plurality of the vias 220 may be disposed on the silicon substrate 210 to implement interconnection between different surface pads of the upper surface of the silicon substrate 210, or electrically interconnection between the different surface pads of the upper surface of the silicon substrate 210 and another electrical element at the lower surface of the through silicon via chip.

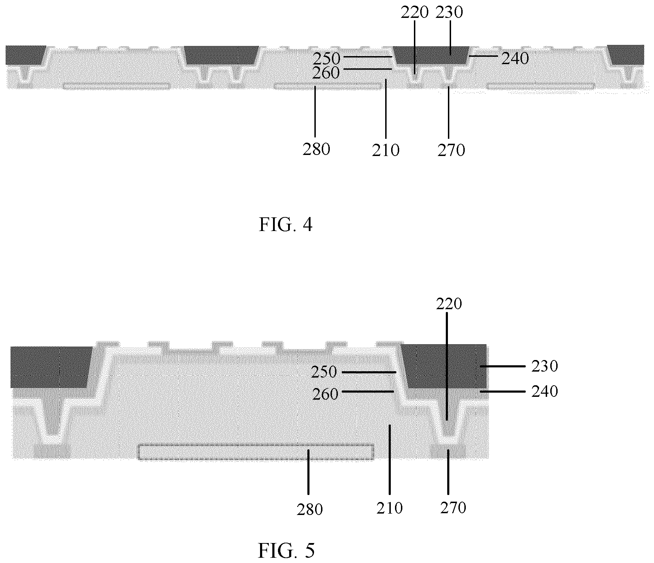

Specifically, in practical production, main steps of manufacturing process of the backfill structure layer 230 are as follows:
a. Manufacture of a wafer level oblique through silicon via is completed, and FIG 3 shows morphology of a plurality of inverted wafer level oblique through silicon via chips before a wafer is cut.
b. As shown in FIG. 4, colloid covers a back of the wafer (i.e., a hollow part of the large hole) completely by operations such as spraying or whirl coating, and colloid filled at the step is retained and the rest of collide is removed by processes such as photolithography and development. Or, a mold having a specific shape may be placed at the hollow part of the large hole, and plastics is injected into the step by injection molding.
c. The wafer is cut after completion of filling, and then an oblique through silicon via chip with a reinforced structure is obtained, as shown in FIG. 5.

It should be noted that, the foregoing application is only exemplified. In a practical case, such through silicon via chip may be generated in other manners, which is not limited in the embodiment of the present application.

An embodiment of the present application further provides a fingerprint identification sensor, where the fingerprint identification sensor includes the foregoing through silicon via chip. The through silicon via chip includes a silicon substrate, the silicon substrate is provided with a via, the via is an oblique via, and a backfill structure layer is disposed in the via, where a lower surface of the backfill structure layer is flush with a lower surface of the through silicon via chip. As shown in FIG.2, the fingerprint identification sensor may include a pixel area 280.

An embodiment of the present application further provides a terminal device, where the terminal device includes the foregoing through silicon via chip. The through silicon via chip includes a silicon substrate, the silicon substrate is provided with a via, the via is an oblique via, and a backfill structure layer is disposed in the via, where a lower surface of the backfill structure layer is flush with a lower surface of the through silicon via chip.

According to the though silicon via chip of the embodiments of the present application, a backfill structure is added in an oblique via to play a supportive role when a test or a process such as surface bonding and welding is performed on a surface pad of the through silicon via chip, which avoids a fracture of the through silicon via chip, thereby enhancing structural strength of the through silicon via chip on the basis of low cost.

Those skilled in the art may clearly understand that, for the convenience and simplicity of description, the specific working processes of the system, the through silicon via chip and the units described above may refer to corresponding processes in the foregoing method embodiments, and will not be repeated redundantly herein.

The foregoing descriptions are merely specific embodiments of the present invention, but are not intended to limit the protection scope of the claims.

## Claims

1. A through silicon via chip, wherein the through silicon via chip comprises a silicon substrate (210), the silicon substrate is provided with a via (220), the via (220) is a step structure with inclined sidewalls, and a backfill structure layer (230) is disposed in the via (220);
wherein a first insulating layer (240), a rewiring metal layer (250) and a second insulating layer (260) are orderly disposed between the backfill structure layer (230) and the silicon substrate (210); and **characterized in that**
the first insulating layer (240), the rewiring metal layer (250) and the second insulating layer (260) extend to a lower surface of the through silicon via chip, and a lower surface of the backfill structure layer (230) is flush with a lower surface of an aggregation of the through silicon via chip, the first insulating layer (240), the rewiring metal layer (250) and the second insulating layer (260).

2. The through silicon via chip of claim 1, wherein a surface pad (270) is disposed at a top of the via (220), and a lower surface of the surface pad (270) is connected with the rewiring metal layer (250).

3. The through silicon via chip of claim 2, wherein the surface pad (270) is embedded in an upper surface of the silicon surface (210) and covers the via (220), and no insulating layer is disposed between the surface pad (270) and the rewiring metal layer (250).

4. The through silicon via chip of claim 3, wherein the first insulating layer (240), the rewiring metal layer (250) and the second insulating layer (260) are orderly disposed outwardly from a center axis of the via (220), and the surface pad (270) and the rewiring metal layer (250) are conductive with each other to implement electrical interconnection between an electrical element of an upper surface of the through silicon via chip and an electrical element of a lower surface of the through silicon via chip.

5. The through silicon via chip of claim 1, wherein a wall of the via (220) is at an angle of 60 degree with respect to an upper surface of the through silicon via chip.

6. The through silicon via chip of claim 1, wherein the silicon substrate (210) is provided with a plurality of the vias (220).

7. The through silicon via chip of claim 6, wherein the plurality of the vias (220) are configured to implement interconnection between different surface pads (270) of an upper surface of the silicon substrate (210); or
the plurality of the vias are configured to implement electrical interconnection between different surface pads (270) of an upper surface of the silicon substrate (210) and other element of a lower surface of the through silicon via chip.

8. A terminal device, wherein the terminal device comprises the through silicon via chip of any one of claims 1 to 7.

9. A method of manufacturing the through silicon via chip of any one of claims 1 to 7, wherein the method comprises:
manufacturing a wafer level through silicon via chip on a wafer to obtain a wafer having a plurality of wafer level through silicon via chips, wherein a via of each wafer level through silicon via chip has a step structure;
filling colloid into the step structure of the wafer level through silicon chip to form a backfill structure layer;
cutting the wafer to obtain a through silicon via chip with a reinforced structure after completion of the colloid filling.

10. The manufacturing method of the through silicon via chip of claim 9, wherein the filling the colloid into the step structure of the wafer level through silicon chip comprises: covering a back of the wafer with colloid completely by spraying or whirl coating, and removing colloid on the wafer level through silicon via chip excluding the step structure by photolithography and development processes to retain colloid filled in the step structure.

11. The manufacturing method of the through silicon via chip of claim 9, wherein the filling the colloid into the step structure of the wafer level through silicon chip comprises: placing a mold having a specific shape at a back of the wafer, and injecting plastics into the step structure with the mold by injection molding.

## Patentansprüche

1. Silizium-Durchkontaktierung-Chip, wobei der Silizium-Durchkontaktierung-Chip ein Siliziumsubstrat (210) umfasst, wobei das Siliziumsubstrat mit einer Durchkontaktierung (220) vorgesehen ist, wobei die Durchkontaktierung (220) eine Stufenstruktur mit geneigten Seitenwänden ist und eine Hinterfüllungsstrukturschicht (230) in der Durchkontaktierung (220) angeordnet ist;
wobei eine erste Isolierschicht (240), eine Neuverdrahtungsmetallschicht (250) und eine zweite Isolierschicht (260) geordnet zwischen der Hinterfüllungsstrukturschicht (230) und dem Siliziumsubstrat (210) angeordnet sind; und
**dadurch gekennzeichnet, dass**
sich die erste Isolierschicht (240), die Neuverdrahtungsmetallschicht (250) und die zweite Isolierschicht (260) zu einer unteren Fläche des Silizium-Durchkontaktierung-Chips erstrecken und eine untere Fläche der Hinterfüllungsstrukturschicht (230) mit einer unteren Fläche einer Ansammlung des Silizium-Durchkontaktierung-Chips, der ersten Isolierschicht (240), der Neuverdrahtungsmetallschicht (250) und der zweiten Isolierschicht (260) bündig ist.

2. Silizium-Durchkontaktierung-Chip nach Anspruch 1, wobei ein Flächenkontaktfleck (270) an einem Oberteil der Durchkontaktierung (220) angeordnet ist und eine untere Fläche des Flächenkontaktflecks (270) mit der Neuverdrahtungsmetallschicht (250) verbunden ist.

3. Silizium-Durchkontaktierung-Chip nach Anspruch 2, wobei der Flächenkontaktfleck (270) in einer oberen Fläche der Siliziumfläche (210) eingebettet ist und die Durchkontaktierung (220) abdeckt und keine Isolierschicht zwischen dem Flächenkontaktfleck (270) und der Neuverdrahtungsmetallschicht (250) angeordnet ist.

4. Silizium-Durchkontaktierung-Chip nach Anspruch 3, wobei die erste Isolierschicht (240), die Neuverdrahtungsmetallschicht (250) und die zweite Isolierschicht (260) von einer Mittelachse der Durchkontaktierung (220) nach außen geordnet angeordnet sind und der Flächenkontaktfleck (270) und die Neuverdrahtungsmetallschicht (250) miteinander leitend sind, um eine elektrische Verbindung zwischen einem elektrischen Element einer oberen Fläche des Silizium-Durchkontaktierung-Chips und einem elektrischen Element einer unteren Fläche des Silizium-Durchkontaktierung-Chips zu implementieren.

5. Silizium-Durchkontaktierung-Chip nach Anspruch 1, wobei eine Wand der Durchkontaktierung (220) in einem Winkel von 60 Grad in Bezug auf eine obere Fläche des Silizium-Durchkontaktierung-Chips ist.

6. Silizium-Durchkontaktierung-Chip nach Anspruch 1, wobei das Siliziumsubstrat (210) mit mehreren Durchkontaktierungen (220) vorgesehen ist.

7. Silizium-Durchkontaktierung-Chip nach Anspruch 6, wobei die mehreren Durchkontaktierungen (220) eingerichtet sind, um eine Verbindung zwischen unterschiedlichen Flächenkontaktflecken (270) einer oberen Fläche des Siliziumsubstrats (210) zu implementieren; oder
die mehreren Durchkontaktierungen eingerichtet sind, um eine elektrische Verbindung zwischen unterschiedlichen Flächenkontaktflecken (270) einer oberen Fläche des Siliziumsubstrats (210) und einem anderen Element einer unteren Fläche des Silizium-Durchkontaktierung-Chips zu implementieren.

8. Endgerätvorrichtung, wobei die Endgerätvorrichtung den Silizium-Durchkontaktierung-Chip nach einem der Ansprüche 1 bis 7 umfasst.

9. Verfahren zum Herstellen des Silizium-Durchkontaktierung-Chips nach einem der Ansprüche 1 bis 7, wobei das Verfahren umfasst:
Herstellen eines Waferebene-Silizium-Durchkontaktierung-Chips auf einem Wafer, um einen Wafer mit mehreren Waferebene-Silizium-Durchkontaktierung-Chips zu erhalten, wobei eine Durchkontaktierung jedes Waferebene-Silizium-Durchkontaktierung-Chips eine Stufenstruktur aufweist;
Füllen von Kolloid in die Stufenstruktur des Waferebene-Silizium-Durchkontaktierung-Chips, um eine Hinterfüllungsstrukturschicht zu bilden;
Schneiden des Wafers, um einen Silizium-Durchkontaktierung-Chip mit einer verstärkten Struktur nach Abschluss des Kolloid-Füllens zu erhalten.

10. Herstellungsverfahren des Silizium-Durchkontaktierung-Chips nach Anspruch 9, wobei das Füllen des Kolloids in die Stufenstruktur des Waferebene-Silizium-Durchkontaktierung-Chips umfasst: vollständiges Abdecken eines Rückens des Wafers mit Kolloid durch Sprühen oder Wirbelbeschichten und Entfernen von Kolloid auf dem Waferebene-Silizium-Durchkontaktierung-Chip ausgenommen der Stufenstruktur durch Fotolithographie und Entwicklungsvorgänge, um Kolloid zu erhalten, das in die Stufenstruktur gefüllt ist.

11. Herstellungsverfahren des Silizium-Durchkontaktierung-Chips nach Anspruch 9, wobei das Füllen des Kolloids in die Stufenstruktur des Waferebene-Silizium-Durchkontaktierung-Chips umfasst: Platzieren einer Form mit einer spezifischen Form an einem Rücken des Wafers und Einspritzen von Kunststoffen in die Stufenstruktur mit der Form durch Spritzgießen.

## Revendications

1. Puce à trous de liaison à travers le silicium, dans laquelle la puce à trous de liaison à travers le silicium comprend un substrat de silicium (210), le substrat de silicium est pourvu d'un trou de liaison (220), le trou de liaison (220) est une structure étagée avec des parois latérales inclinées, et une couche de structure de remplissage (230) est disposée dans le trou de liaison (220);
dans laquelle une première couche isolante (240), une couche métallique de recâblage (250) et une seconde couche isolante (260) sont disposées dans cet ordre entre la couche de structure de remplissage (230) et le substrat de silicium (210); et **caractérisée en ce que**
la première couche isolante (240), la couche métallique de recâblage (250) et la seconde couche isolante (260) s'étendent vers une surface inférieure de la puce à trous de liaison à travers le silicium, et une surface inférieure de la couche de structure de remplissage (230) est de niveau avec une surface inférieure d'une agrégation de la puce à trous de liaison à travers le silicium, de la première couche isolante (240), de la couche métallique de recâblage (250) et de la seconde couche isolante (260).

2. Puce à trous de liaison à travers le silicium selon la revendication 1, dans laquelle une pastille de surface (270) est disposée sur une partie supérieure du trou de liaison (220), et une surface inférieure de la pastille de surface (270) est reliée à la couche métallique de recâblage (250).

3. Puce à trous de liaison à travers le silicium selon la revendication 2, dans laquelle la pastille de surface (270) est noyée dans une surface supérieure de la surface de silicium (210) et recouvre le trou de liaison (220), et aucune couche isolante n'est disposée entre la pastille de surface (270) et la couche métallique de recâblage (250).

4. Puce à trous de liaison à travers le silicium selon la revendication 3, dans laquelle la première couche isolante (240), la couche métallique de recâblage (250) et la seconde couche isolante (260) sont disposées dans cet ordre vers l'extérieur à partir d'un axe central du trou de liaison (220), et la pastille de surface (270) et la couche métallique de recâblage (250) sont conductrices l'une avec l'autre pour mettre en œuvre une interconnexion électrique entre un élément électrique d'une surface supérieure de la puce à trous de liaison à travers le silicium et un élément électrique d'une surface inférieure de la puce à trous de liaison à travers le silicium.

5. Puce à trous de liaison à travers le silicium selon la revendication 1, dans laquelle une paroi du trou de liaison (220) est à un angle de 60 degrés par rapport à une surface supérieure de la puce à trous de liaison à travers le silicium.

6. Puce à trous de liaison à travers le silicium selon la revendication 1, dans laquelle le substrat de silicium (210) est pourvu d'une pluralité des trous de liaison (220).

7. Puce à trous de liaison à travers le silicium selon la revendication 6, dans laquelle la pluralité des trous de liaison (220) sont configurés pour mettre en œuvre une interconnexion entre différentes pastilles de surface (270) d'une surface supérieure du substrat de silicium (210) ; ou la pluralité des trous de liaison sont configurés pour mettre en œuvre une interconnexion électrique entre différentes pastilles de surface (270) d'une surface supérieure du substrat de silicium (210) et un autre élément d'une surface inférieure de la puce à trous de liaison à travers le silicium.

8. Dispositif terminal, dans lequel le dispositif terminal comprend la puce à trous de liaison à travers le silicium selon l'une quelconque des revendications 1 à 7.

9. Procédé de fabrication de la puce à trous de liaison à travers le silicium selon l'une quelconque des revendications 1 à 7, dans lequel le procédé comprend de :
fabriquer une puce à trous de liaison à travers le silicium de niveau tranche sur une tranche pour obtenir une tranche ayant une pluralité de puces à trous de liaison à travers le silicium de niveau tranche, dans lequel un trou de liaison de chaque puce à trous de liaison à travers le silicium de niveau tranche a une structure étagée;
remplir la structure étagée de la puce à travers le silicium de niveau tranche avec un colloïde pour former une couche de structure de remplissage;
découper la tranche pour obtenir une puce à trous de liaison à travers le silicium avec une structure renforcée après l'achèvement du remplissage de colloïde.

10. Procédé de fabrication de la puce à trous de liaison à travers le silicium selon la revendication 9, dans lequel le dépôt du colloïde dans la structure étagée de la puce à travers le silicium de niveau tranche comprend de : recouvrir complètement un dos de la tranche avec un colloïde par pulvérisation ou enduction à la tournette, et retirer le colloïde sur la puce à trous de liaison à travers le silicium de niveau tranche à l'exclusion de la structure étagée par des procédés de photolithographie et de développement pour maintenir le colloïde déposé dans la structure étagée.

11. Procédé de fabrication de la puce à trous de liaison à travers le silicium selon la revendication 9, dans lequel le dépôt du colloïde dans la structure étagée de la puce à travers le silicium de niveau tranche comprend de : placer un moule ayant une forme spécifique sur un dos de la tranche, et injecter une matière plastique dans la structure étagée avec le moule par moulage par injection.
